# EUROPEAN PATENT APPLICATION

(11) **EP 2 660 195 A1**
(43) Date of publication of application: **06.11.2013**
(21) Application number: 10861324.1
(22) Date of filing: 28.12.2010
(51) Int. Cl.: C01B 19/00

(54) **PROCESS FOR PRODUCTION OF COMPOUND HAVING CHALCOPYRITE STRUCTURE**

(71) Applicant: Tohoku Seiki Industries Co., Ltd., Yamagata 990-2251 (JP)
(72) Inventor: MORIYA, Koji, Yamagata-shi Yamagata 990-2251 (JP); NAGAOKA, Jiro, Yamagata-shi Yamagata 990-2251 (JP); TAKANO, Yoshinobu, Yamagata-shi Yamagata 990-2251 (JP); SANO, Yuuki, Yamagata-shi Yamagata 990-2251 (JP); HARADA, Keitaro, Yamagata-shi Yamagata 990-2251 (JP); YOKOO, Masayoshi, Yamagata-shi Yamagata 990-2251 (JP)
(74) Representative: Ulmann, Catherine Claire
(86) International application number: PCT/JP2010/073909
(87) International publication number: WO 2012/090339

(57) **Abstract**

To obtain high-quality chalcopyrite particles having a small particle size using a relatively inexpensive raw material in a simple and easy process in which complicated equipment (such as vacuum equipment) is not necessary. Provided is a method for producing a compound having a chalcopyrite structure represented by a compositional formula: ABC₂, the method including: a step of dissolving a Group 11 element A, a Group 13 element B, and a Group 16 element C of the periodic table in a solvent to prepare a solution; and a step of contacting the solution with a reducing agent.

## Description

### Technical Field

The present invention relates to a method for producing a compound having a chalcopyrite structure. In addition, the present invention relates to a method for producing an optoelectronic device, such as a solar cell, using the obtained compound having a chalcopyrite structure, and the like.

### Background Art

Current mainstream solar cells are made of silicon. However, silicon solar cells have problems such as: the expensive raw material and vacuum process increase the cost of production equipment; and raw material deposition also on other parts than the substrate degrades the utilization efficiency of the raw material. Thus, cost reduction of the silicon solar cells has limitations. In order to promote widespread use of solar cells, a solar cell that is cheaper is needed.

A chalcopyrite compound semiconductor of Group 11-13-15₂, such as CuInSe₂, has a direct transition-type energy band gap, achieving very high light-absorption coefficient. Accordingly, even with a thin film of a few micrometers, a highly efficient solar cell can be produced, and therefore a chalcopyrite compound semiconductor is greatly expected to be used as a material for a light absorption layer of solar cells. In particular, a Cu(InGa)Se₂ (hereinafter abbreviated as CIGS) solar cell is characterized by the highest power generation efficiency (19%), a film thickness of one hundredth that of a silicon solar cell, half the process of silicon solar cell production, and no photodegradation, and therefore expected as an alternative to the existing expensive silicon solar cells.

Examples of a method using a vacuum to form a chalcopyrite compound such as CIGS include multi-source vapor deposition and selenization method.
The multi-source vapor deposition is a method for depositing respective elements as raw materials and can achieve high efficiency of 18% or more in a small-area cell. Usually, a substrate is fixed and a deposition element is selected by opening and closing of a shutter arranged in front of a deposition source to form a film of a chalcopyrite compound. There is even a reported case in which the U.S. National Renewable Energy Laboratory (NREL) used the above method to produce a CIGS solar cell exhibiting an energy conversion efficiency of 19.5%.
In the selenization method, first, a metal precursor made of Cu-In-Ga or the like is deposited by sputtering and then thermally treated under a diluted H₂Se atmosphere to form a chalcopyrite compound film.

Regarding these methods, production of solar cells having high conversion efficiency have been reported, but the methods are difficult in scaling-up due to the use of vacuum equipment and increase in initial investment cost due to the expensive vacuum equipment. Additionally, since the selenization method needs to use dangerous H₂Se in selenization, a safer process is desired.

On the other hand, as a method achieving low cost and facilitating area increase, a method is under study, in which particles are deposited on a substrate by spraying, screen printing, inkjet printing, a doctor blade method, or the like, and then thermally treated to produce a light absorption layer of a solar cell.

Such a method requires a step of synthesizing the particles. If a chalcopyrite compound or precursor particles thereof can be obtained in a state of nanoparticles, it is advantageous in terms of the formation of a film by printing, spraying, or the like. Various methods for the synthesis have been reported.

Li et al. (1999) Advanced Materials 11:1456-9., (Non-Patent Literature 1) has reported a method for synthesizing CIS nanoparticles by adding raw powdered CuCl₂, InCl₃, and Se into a solvent of ethylenediamine and diethylamine to react by a solvothermal method. However, there are problems in that since the strongly basic, harmful amine compounds are used as the solvent, it is difficult to produce and separate a precursor, as well as the reaction needs to be performed at a high temperature of 180°C or higher for a long reaction time of one day or more.

In addition, U.S. Patent No. 612740 (Patent Literature 1) has reported that CIGS can be obtained by reacting a pyridine solvent containing CuI, InI₃, and GaI₃ with a methanol solvent containing Na₂Se at low temperature. This method is disadvantageous in that pretreatments for deoxidation and dewatering are needed and the entire process needs to be performed under an inert atmosphere. Furthermore, it is problematic that Na₂Se is not a commonly-used material and expensive.

Furthermore, T. Wada et al. (2006) Phys. Stat. Sol. (a) 203, 2593., (Non-Patent Literature 2) has reported a method for synthesizing chalcopyrite particles by a mechanochemical process. The method is a process in which mechanical energy such as pulverization, friction, compression, or the like is applied to element powder as a raw material to cause physical and chemical changes by the mechanical energy. The method is characterized by high energy efficiency, high productivity, and short cycle time. However, the chalcopyrite particles obtained by the method have a relatively large particle size of 0.1 to 0.7 µm. Thus, when the particles are applied to an optoelectronic device or the like, there seem to be limitations on the increase of power generation efficiency.

### Citation List

### Patent Literature

Patent Literature 1: U.S. Patent No. 612740 Non-Patent Literature

Non-Patent Literature 1: Li et al. (1999) Advanced Materials 11:1456-9.
Non-Patent Literature 2: T. Wada et al. (2006) Phys. Stat. Sol. (a) 203, 2593.

### SUMMARY OF INVENTION

As described above, many methods for synthesizing chalcopyrite particles have been reported. However, it has been difficult to obtain high-quality chalcopyrite particles having a small particle size using a relatively inexpensive raw material in a simple and easy process that requires no complicated equipment (such as vacuum equipment).
The present inventors have discovered a method for producing high-quality chalcopyrite particles having a small particle size, which solves the above problems.

In order to solve the above problems, the present invention provides the following aspects:
(1) A method for producing a compound having a chalcopyrite structure represented by a compositional formula: ABC₂, the method including:
   a step of dissolving a Group 11 element A, a Group 13 element B, and a Group 16 element C of the periodic table in a solvent to prepare a solution; and
   a step of contacting the solution with a reducing agent.

(2) The method according to the (1), in which the compound having a chalcopyrite structure is present in a dispersed state in the solution.

(3) The method according to the (1) or (2), in which the compound having a chalcopyrite structure includes particles in size from nanometer to submicron order.

(4) The method according to any one of the (1) to (3), in which the Group 11 element A, the Group 13 element B, and the Group 16 element C are prepared in a form of a compound or a single substance having solubility in the solvent at 20±15°C.

(5) The method according to the (4), in which in the compound of the Group 16 element C, the valence of the Group 16 element C is not -II.

(6) The method according to any one of the (1) to (5), in which the solvent includes at least one of a polar solvent and a nonpolar solvent.

(7) The method according to any one of the (1) to (6), in which the polar solvent and the nonpolar solvent are used in combination as the solvent and these solvents are contacted with a phase-transfer catalyst.

(8) The method according to any one of the (1) to (7), in which the reducing agent is at least one selected from the group consisting of a hydride reducing agent, hydrazine, oxalic acid, ascorbic acid, formaldehyde, acetaldehyde, and sodium sulfite, or a combination of any thereof.

(9) A method for producing a coating type material or a physical vapor deposition (PVD) material using a compound having a chalcopyrite structure produced by the method according to any one of the (1) to (8).

(10) A method for producing an optoelectronic device using a compound having a chalcopyrite structure produced by the method according to any one of the (1) to (8).

(11) The method according to the (10), in which the optoelectronic device is a solar cell or a photodiode.

### BRIEF DESCRIPTION OF DRAWINGS

FIG. 1 depicts compound production steps in Example 1.
FIG. 2 depicts an XRD analysis chart of a compound produced in Example 1.
FIG. 3 depicts compound production steps in Examples 2 and 3.
FIG. 4 depicts an XRD analysis chart of a compound obtained in Example 2.
FIG. 5 depicts an XRD analysis chart of a compound obtained in Example 3.
FIG. 6 depicts an SEM observation image of the compound obtained in Example 1.
FIGs. 7 depict EDS analysis images of the compound obtained in Example 1.

### DESCRIPTION OF EMBODIMENTS

The method of the present invention produces a compound having a chalcopyrite structure represented by a compositional formula: ABC₂.

Chalcopyrite is an alias of yellow copper ore CuFeS₂. This substance is an antiferromagnetic semiconductor having a tetragonal crystal structure in which sphalerite (ZB) structures typified by ZnS are stacked two high and Zn is orderly replaced by two elements, Cu and Fe. Among chalcopyrite compounds, there is a compound having the same crystalline structure, which has the compositional formula: ABC₂. In the present specification, this is referred to as a compound having a chalcopyrite structure represented by the compositional formula: ABC₂. Such an ABC₂-type compound semiconductor includes two systems: one is a series of Group 14 → Group 13-15 → Group 12-14-15₂ and the other one is Group 14 → Group 12-16 → Group 11-13-16₂.

A method for producing a compound having a chalcopyrite structure represented by the compositional formula: ABC₂ according to the present invention includes a step of dissolving a Group 11 element A, a Group 13 element B, and a Group 16 element C of the periodic table in a solvent to prepare a solution. Along this step, the present invention will be described in detail hereinbelow.

As the Group 11 element A of the periodic table, any of Cu, Ag, Au or a combination of any thereof may be used. As the Group 13 element B of the periodic table, B(boron), any of Al, Ga, In, and Tl or a combination of any thereof may be used. As the Group 16 element C of the periodic table, any of S, Se, Te, and Po or a combination of any thereof may be used.

By setting the mixed amounts of the elements A, B, and C to an atomic weight ratio of 1:1:2, there can be obtained a compound having a chalcopyrite structure represented by the compositional formula: ABC₂. The compositional formula: ABC₂ is a composition used as a base, by which the mixed amounts of the elements A, B, and C can be appropriately fine-adjusted so that the composition can be used as a compound semiconductor. Specifically, if the total of the atomic weights of the Group 11 element A and the Group 13 element B is larger than the atomic weight of the Group 16 element C, the compound is a p-type semiconductor, whereas if the total of the atomic weights thereof is smaller than that, the compound is an n-type semiconductor. In addition, the atomic weights of the Group 11 element A and the Group 13 element B can also be properly adjusted. In this way, adjustment of the ratio of these elements allows the compound semiconductor to be adjusted to either p-type or n-type.

In addition, the elements A, B, and C each do not have to be one element and may be a combination of elements of the same Group in the periodic table. As the element B, Ga and In may be used in an atomic weight ratio of 1:1. As the element C, S and Se may be used in an atomic weight ratio of 1:1. In this manner, by adjusting the ratio of these elements, the band gap of the compound semiconductor can be properly adjusted.

More specifically, compound semiconductors having a chalcopyrite structure, (Ag, Cu) (Al, In, Ga) (S, Se)₂ are known as light-emitting and light receiving materials for infrared light, visible light to ultraviolet light, since the semiconductors have a wide band gap for direct transition of from 1.0 to 3.6 eV. Among the compound semiconductors, particularly, a Cu(In, Ga) (S, Se)₂ compound semiconductor that is a so-called CIGS compound semiconductor using copper (Cu) as the element A, indium (In) and gallium (Ga) as the element B, and sulfur (S) and selenium (Se) as the element C can achieve a band gap of 1.4 eV, which is ideal for the light absorption of a solar cell, by being produced by adjusting a ratio of Indium to Gallium in the element B and a ratio of sulfur to selenium in the element C. Thus, a CIS-based thin film solar cell using such a CIGS compound semiconductor seems to achieve high photoelectric conversion efficiency.

The solvent is not particularly limited as long as it can dissolve the elements A, B, and C. The solvent can be properly selected according to the form of a compound or a single substance including the elements A, B, and C, respectively, such that the elements A, B, and C are dissolved in the solvent. Accordingly, the solvent may include either a polar solvent or a nonpolar solvent.
When the solvent is a polar solvent, it normally has high solvent power for electrolyte compounds and can dissolve many substances that are not dissolved in nonpolar solvents. Water and ethanol are typical hydrogen-bonding polar solvents. In addition, dipolar aprotic solvents having no protic hydrogen, such as N,N-dimethylformaldehyde, N,N-dimethylacetamide, dimethylsulfoxide, N-methylpyrrolidone, and hexamethylphosphoramide, can be used as solvents for polymer compounds, or the like.
When the solvent is a nonpolar solvent, it can normally dissolve substances having small polarity that are not dissolved in polar solvents. Examples of the nonpolar solvent that can be used include hexane, benzene, toluene, diethylether, chloroform, ethyl acetate, and methylene chloride.

As the solvent, a polar solvent and a nonpolar solvent may be used in combination and these solvents may be contacted with a phase-transfer solvent. The phase-transfer solvent is effective since it allows the reaction between an inorganic salt soluble in a polar solvent and an organic compound slightly soluble in the polar solvent. When a phase-transfer catalyst is added to a two-layer solvent system containing a polar solvent layer (water layer) and a nonpolar solvent layer (inorganic layer) in which the respective compounds have been dissolved, the water-soluble inorganic salt transfers to the organic layer and homogeneous phase reaction is promoted in the organic layer, thereby significantly increasing reaction rate. Additionally, the use of the phase-transfer catalyst gives greater choice of combinations of solvent and solute, so that a more proper combination can be employed. That is, when there are a solute easily soluble and a solute slightly soluble in polar solvents, the solute easily soluble in polar solvents is dissolved in a polar solvent, the solute slightly soluble in polar solvents is dissolved in a nonpolar solvent, and these solvents are contacted with a phase-transfer catalyst to allow contact with all the solutes. Examples of effective phase-transfer catalysts include long chain alkyl quaternary salts having length averaged out as much as possible, such as tetrabutylammonium bromide (TBA-Br, (C₄H₉)₄N⁺Br⁻), trioctylmethylammonium chloride (TOMAC, (C₈H₁₇)₃N⁺CH₃Cl⁻), and tetrabutyl phosphonium chloride (TBPC, (C₄H₉)₄P⁺Cl⁻), as well as crown ethers also give good results as neutral catalysts.

Preferably, the elements A, B, and C, respectively, are in a form of a compound or a single substance having solubility in solvent at room temperature, which is defined as a range of 20°C ± 15°C (5 to 35°C) according to JIS Z 8703, but depending on the environment used, the solvent used, the form of the compound or the single substance containing each of the elements A, B, and C, and the like, the above temperature range can be properly adjusted. The form of the compound or the single substance having solubility at room temperature can be properly adjusted according to the above solvent. The compound may be an oxide salt, nitrate, sulfate, carbonate, chloride salt, acetate, or the like. Alternatively, the compound may be a composite salt containing two or more of the elements A, B and C or a complex salt. Having solubility at room temperature means that heating or the like is not particularly needed. Thus, as compared to the conventional solvothermal method and the like, the method of the present invention is a simpler and easier process and therefore advantageous.

The compound of the Group 16 element C may be a compound in which the valence of the Group 16 element C is not -II. Examples of a compound in which the valence of the Group 16 element C is -II include Na₂Se, benzeneselenol, and selenourea. Na₂Se is problematic in that the compound must be handled in an inert atmosphere and is not a commonly-used material and expensive. Benzeneselenol has an unpleaseant odor and is expensive, and selenourea is also an expensive material. The present invention can use other compounds than these expensive compounds.
Additionally, H₂Se is a selenide with a valence of - II, which is in a gas phase. In the conventional compound semiconductor production methods, there are cases in which selenization of a precursor substance is performed by thermal treatment under selenized hydrogen atmosphere (selenization method). However, the selenization method is problematic in that although a thermal treatment furnace is needed, it is very expensive. The present invention allows compound synthesis in liquid phase and thus does not need any expensive thermal treatment furnace, a thermal treatment step using the furnace, and the like.
The present invention may use selenium powder (acid-soluble), halide salts such as selenium tetrachloride (hydrolyzable), selenium bromide (soluble in carbon disulfide, chloroform, and ethyl bromide), and selenium iodide (decomposed in ice water), selenous acid (easily soluble in water and ethanol), selenium dioxide (easily soluble in water, ethanol, and acetic acid), and the like.

The method for producing a compound having a chalcopyrite structure represented by the compositional formula: ABC₂, of the present invention also includes a step of contacting the solution prepared by dissolving the elements A, B, and C with a reducing agent.
Along the step, the present invention will be described in detail hereinbelow.

The reducing agent provides electrons to the elements dissolved in the solution to directly precipitate the elements from the solution, whereby a compound having a chalcopyrite structure represented by the compositional formula: ABC₂ can be obtained. Examples of the reducing agent include hydride reducing agents such as dimethylamine borane, diborane, tert-butylamine borane, sodium borohydride, and lithium aluminum hydride, hydrazine, oxalic acid, ascorbic acid, formaldehyde, acetaldehyde, and sodium sulfite. At least one of these compounds or a combination of any thereof may be used.

As a method for contacting the reducing agent with the elements, an arbitrary method can be employed that allows the contact between the dissolved elements and the reducing agent, in which the reducing agent may be added to the solution or the solution may be added to the reducing agent. The present invention essentially relates to a method for producing a compound having a chalcopyrite structure represented by the compositional formula: ABC₂, and it is obvious that the method of the present invention is also applicable to the syntheses of a composition AC (for example, Cu-Se) and a composition BC (for example, In-Se) as precursors. Accordingly, the reducing agent may be added in a stage of dissolving a part of the elements in the solvent, and then a dissolved solution of the remaining element(s) may be added. For example, when selenium powder (single substance) is used as the Group 16 element C and water is used as a polar solvent, the selenium powder (single substance) is insoluble in water and thus dispersed in water. However, by the addition of a reducing agent, the selenium (single substance) is reduced to become soluble in water. After this, a dissolved solution of the remaining Group 11 element A and Group 13 element B can be added to precipitate a compound. In the contact between the reducing agent and the solution, the contact may be promoted using stirring, ultrasonic irradiation, or the like, but heating and vacuum are not particularly needed.

The precipitated compound having a chalcopyrite structure may be present in a dispersed state in the solution. In order to suppress the aggregation and coagulation of the compound present in the dispersed state, a dispersion stabilizer may be added to the solution. Examples of the dispersion stabilizer that can be used include dodecanethiol, poly(3-hexylthiophene), 3-hexylthiophene, 3-dodecylthiophene, poly(3-pentadecylpyrrole), hexylpyrrole, dodecylpyrrole, hexylthiol, and polyhexylaniline.

In order to extract the compound having a chalcopyrite structure present in the solution, removal of the solvent by an evaporator, separation of a compound fraction by a centrifugal separator, filtering by an ultrafiltration membrane, or the like. Any one of these operations or a combination of any thereof may be used. During the operation(s) or after completion thereof, washing of the resultant compound may be performed. The washing solution can be properly selected according to the solvent, the reducing agent, and the like used for the compound production, or may be selected from ethanol, water, toluene, and the like, for use. The washing and the extraction of the compound by an evaporator, a centrifugal separator, an ultrafiltration membrane, and/or the like may be arbitrarily repeated plural times. After completion of the extraction and the washing, the resultant compound having a chalcopyrite structure may be dried using a desiccator or the like.

The obtained compound having a chalcopyrite structure may include particles in size from nanometer to submicron order. Preferably, the lower limit of the particle size of the compound is a few nm or more and preferably 10 nm or more, and the upper limit of the particle size thereof is 500 nm or less, preferably 100 nm or less, and still more preferably 50 nm or less. When the particle size of the compound is smaller than the range, it may be impossible to form a compound having a chalcopyrite structure represented by the compositional formula: ABC₂. Conversely, when the particle size of the compound is larger than the above range, it is difficult to form the compound into a thin film when applied to an optoelectronic device or the like. The particle size can be calculated from an observation image taken by a transmission electron microscope (SEM).

The present invention also relates to a method for producing an optoelectronic device or the like using the obtained compound having a chalcopyrite structure. The aspect will be described in detail hereinbelow.

Using the obtained compound having a chalcopyrite structure, a coating type material or a physical vapor deposition (PVD) material can be produced.

The coating type material is ink or paste prepared by dispersing the obtained compound having a chalcopyrite structure in, for example, toluene, chloroform, DMF, DMSO, pyridine, alcohol, hydrocarbons, or the like. The coating type material may further encompass dispersants, for example, alkane selenol, alkane thiol, alcohol, aromatic selenol, aromatic thiol, and aromatic alcohol.

The coating type materials above can be coated on a substrate by spray, screen printing, inkjet printing, doctor blade method, or the like. The coating type material coated is thermally treated to remove the solvent and/or the dispersant, whereby only the compound having a chalcopyrite structure is sintered on the substrate, resulting in the formation of a compound semiconductor layer. Using the compound semiconductor layer, an optoelectronic device can be produced.

The physical vapor deposition (PVD) material can be produced from the obtained compound having a chalcopyrite structure using a technique such as baking method or hot press. Commonly used steps can be employed, such as pulverization, mixing, calcination, molding, and sintering of the powder of the compound.

The above physical vapor deposition (PVD) material can be used as a target of sputtering. By the sputtering, a compound semiconductor layer is formed on a substrate using, as a raw material, the compound having a chalcopyrite structure. The compound semiconductor layer can be a part of an optoelectronic device.

The optoelectronic device includes a device for converting electric energy into light and a device for conversely converting light into electric energy. Typical examples of the former include light-emitting diodes and semiconductor lasers, and those of the latter include photo diodes and solar cells.

Hereinbelow, the present invention will be described in detail with reference to Examples, but the scope of the present invention is not limited to the content of the Examples.

### EXAMPLES

### Example 1

### (Synthesis of Chalcopyrite Particle Dispersion Solution by Water-Toluene Two Phase Method)

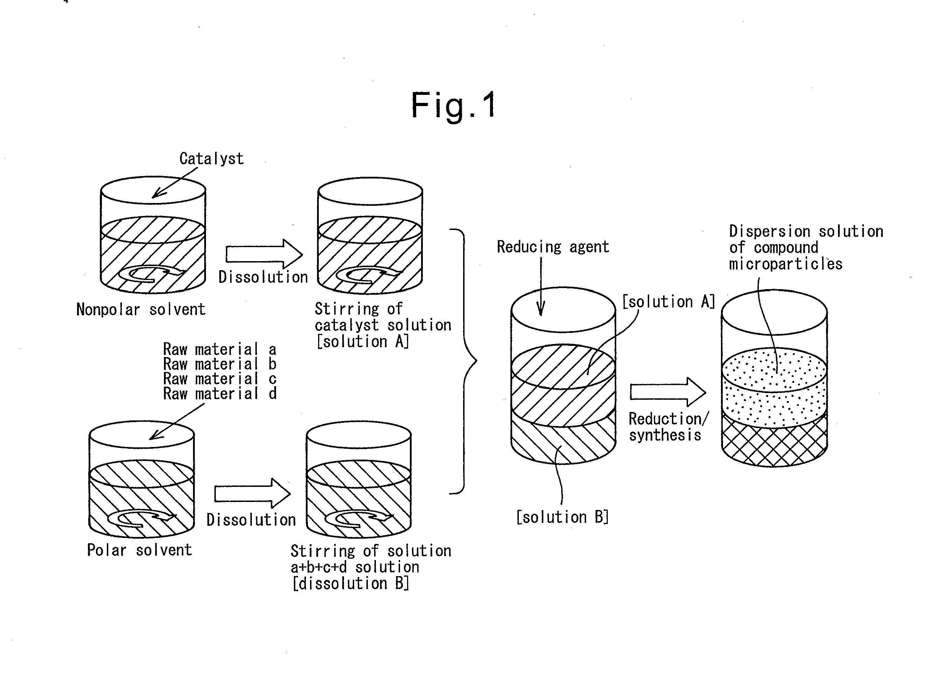

With reference to FIG. 1, a description will be given of Example 1 synthesizing a chalcopyrite particle dispersion solution by a water-toluene two phase method.
In a nonpolar solvent, toluene (50 ml, manufactured by Wako Pure Chemical Industries, Ltd., purity: 99.5%) was mixed a phase-transfer catalyst, tetrabutylammonium bromide (1.61 g, manufactured by Tokyo Chemical Industry Co., Ltd., purity: 98.0%), and the mixture was strongly stirred at room temperature (20°C) by a magnetic stirrer (The resultant solution is referred to as a solution A).
On the other hand, copper nitrate trihydrate (0.5 g, manufactured by Wako Pure Chemical Industries, Ltd., purity: 99.0%), indium nitrate trihydrate (0.43 g, manufactured by Wako Pure Chemical Industries, Ltd., purity: 98.0%), gallium nitrate trihydrate (0.16 g, manufactured by Wako Pure Chemical Industries, Ltd., purity: 99.9%), and selenium tetrachloride (0.883 g, manufactured by Wako Pure Chemical Industries, Ltd., purity: 98.0%) were dissolved in ion exchange water (100 ml) to prepare a solution (the resultant solution is referred to as a solution B).
The solution A and the solution B were mixed together at room temperature (20°C) and the mixed solution was strongly stirred by a magnetic stirrer for 30 minutes.
After that, into the mixed solution was mixed a solution of a protection agent, dodecanethiol (1.92 ml, manufactured by Wako Pure Chemical Industries, Ltd., purity: 98.0%) dissolved in toluene (70 ml, manufactured by Wako Pure Chemical Industries, Ltd., purity: 99.5%), and the obtained mixed solution was strongly stirred by a magnetic stirrer for more 10 minutes. Then, to the mixed solution was added an aqueous solution of a reducing agent, sodium borohydride (3.63 g, manufactured by Wako Pure Chemical Industries, Ltd., purity: 95.0%) dissolved in 100 ml of ion exchange water. The resultant solution was strongly stirred by a magnetic stirrer for 8 hours and the water layer was removed by a separating funnel to obtain a chalcopyrite particle dispersion solution.

### (Recovery of Chalcopyrite Particles)

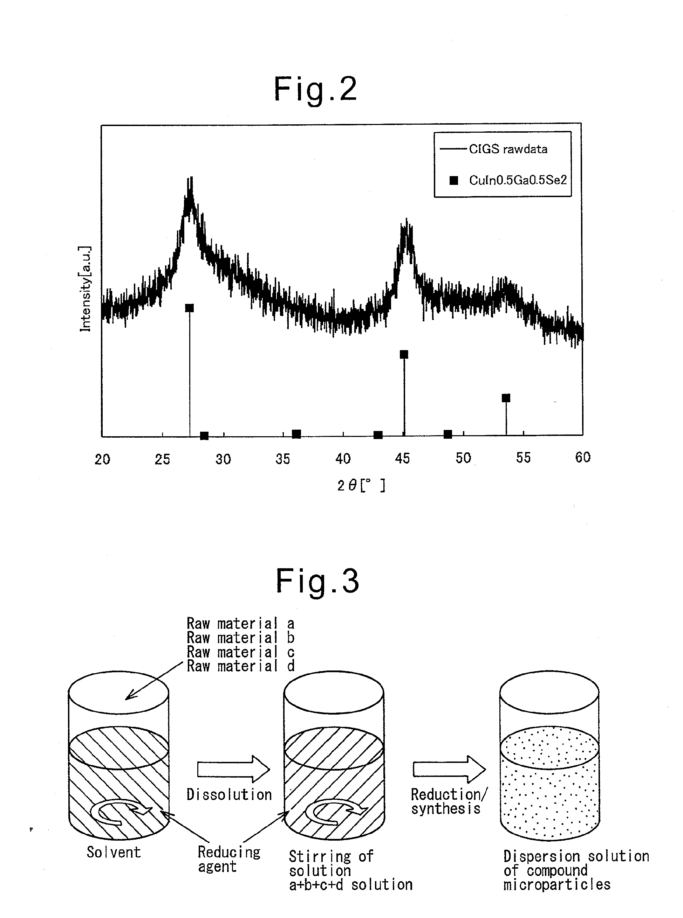

From the above chalcopyrite dispersion solution, the solvent was removed using an evaporator (RE301, manufactured by Yamato Scientific Co., Ltd., under reduced pressure (200 hPa)), and ethanol was added for washing, followed by recovery using centrifugation (CN-2060, manufactured by As One Corporation, 4300 rmp., 15 minutes) and then drying. FIG. 2 depicts a result of XRD (RAD-2B with a graphite monochromator, manufactured by Rigaku Corporation, Cu: 2kW, 2*θ*/*θ* measurement, 4°/min) of the resultant powder. The result of FIG. 2 confirmed that chalcopyrite particles of CuIn_{0.5}GaO_{0.5}Se₂ were produced.

### Example 2

### (Synthesis of Chalcopyrite Particles Using Water Alone as Solvent)

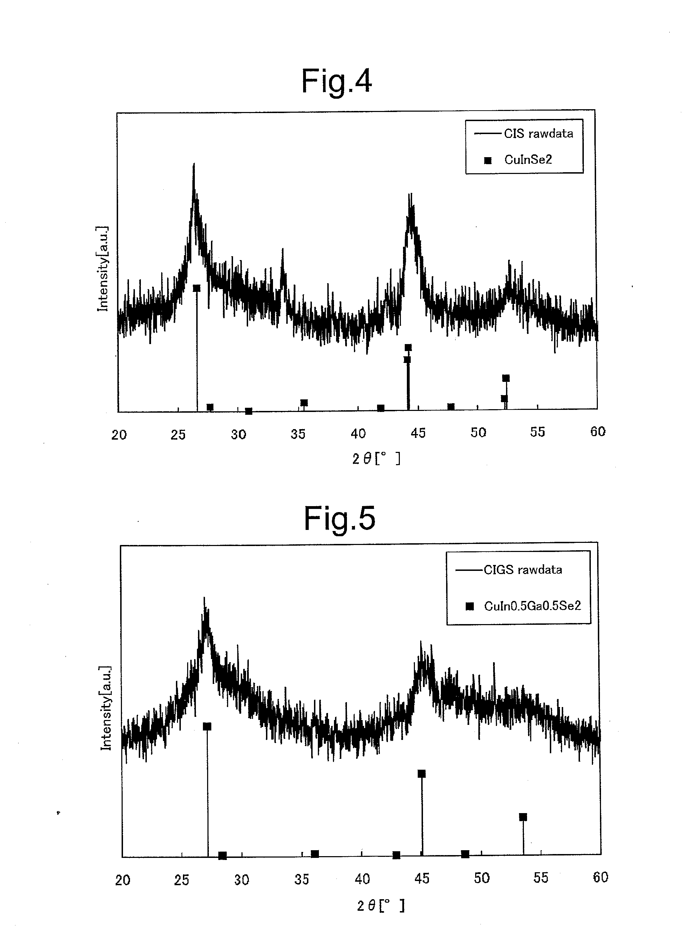

With reference to FIG. 3, a description will be given of Example 2 synthesizing chalcopyrite particles using water alone as a solvent.
To ion exchange water (250 ml) were added copper nitrate trihydrate (1.45 g, manufactured by Wako Pure Chemical Industries, Ltd., purity: 99.0%), indium nitrate trihydrate (2.13 g, manufactured by Wako Pure Chemical Industries, Ltd., purity: 98.0%), and selenium tetrachloride (2.65 g, manufactured by Wako Pure Chemical Industries, Ltd., purity: 98.0%), and the mixture was stirred at room temperature (20°C) for 5 minutes by a magnetic stirrer at moderate strength (the resultant solution is referred to as a solution A).
On the other hand, a solution of a reducing agent, sodium borohydride (4.54 g, manufactured by Wako Pure Chemical Industries, Ltd., purity: 95.0%) dissolved in ion exchange water (50 ml) was prepared and added to the solution A. The mixed solution was strongly stirred at room temperature (20°C) for 1 hour by a magnetic stirrer.
After that, the solution was subjected to centrifugation (CN-2060, manufactured by As One Corporation, 4300 rmp, 15 minutes) to repeat the removal of the solvent and washing with ethanol (manufactured by Wako Pure Chemical Industries, Ltd., purity: 99.5%) and then the residue was dried to obtain particles. FIG. 4 depicts a result of XRD (RAD-2B with a graphite monochromator, manufactured by Rigaku Corporation, Cu: 2kW, 2*θ*/*θ* measurement, 4°/min) of the resultant powder. The result of FIG. 4 confirmed that chalcopyrite particles of CuInSe₂ were produced.

### Example 3

### (Synthesis of Chalcopyrite Particle Dispersion Solution Using Water as Main Solvent)

With reference to FIG. 3, a description will be given of Example 3 synthesizing a chalcopyrite particle dispersion solution using water as a main solvent.
In 90 ml of ion exchange water was dispersed selenium powder (0.79 g, manufactured by Kojundo Chemical Laboratory Co., Ltd., purity: 99.9%), and the dispersion solution was subjected to stirring under cooling (in which ice water was filled in a container and a beaker was placed on the ice water to stir the dispersion solution by a magnetic stirrer at moderate strength). When the temperature of the dispersion solution went down to 0°C, a solution of a reducing agent, sodium borohydride (0.76 g, manufactured by Wako Pure Chemical Industries, Ltd., purity: 95.0%) dissolved in 10 ml of ion exchange water was added thereto to obtain a transparent solution (a solution A).
On the other hand, copper(II) chloride (0.67 g, manufactured by Wako Pure Chemical Industries, Ltd., purity: 95.0%), indium(III) chloride (0.77 g, manufactured by Tokyo Chemical Industry Co., Ltd., purity 98.0 g), and gallium(III) chloride (0.26 g, manufactured by Wako Pure Chemical Industries, Ltd., purity: 99.0%) were dissolved in pyridine (100 ml) set at 70°C to prepare a solution. The obtained solution was mixed with the solution A, and then the mixed solution was strongly stirred by a magnetic stirrer for 20 minutes to obtain a chalcopyrite dispersion solution.

### (Recovery of Chalcopyrite Particles)

The chalcopyrite dispersion solution was subjected to centrifugation (CN-2060, manufactured by As One Corporation, 4300 rmp, 15 minutes) to recover the particles. After washing with ethanol (manufactured by Wako Pure Chemical Industries, Ltd., purity: 99.5%), further centrifugation (CN-2060, manufactured by As One Corporation, 4300 rmp, 15 minutes) was performed for recovery, followed by drying. FIG. 5 depicts a result of XRD (RAD-2B with a graphite monochrometer, manufactured by Rigaku Corporation, Cu: 2kW, 2*θ*/*θ* measurement, 4°/min) of the resultant powder. The result of FIG. 5 confirmed that chalcopyrite particles of CuIn_{0.5}GaO_{0.5}Se₂ were produced.

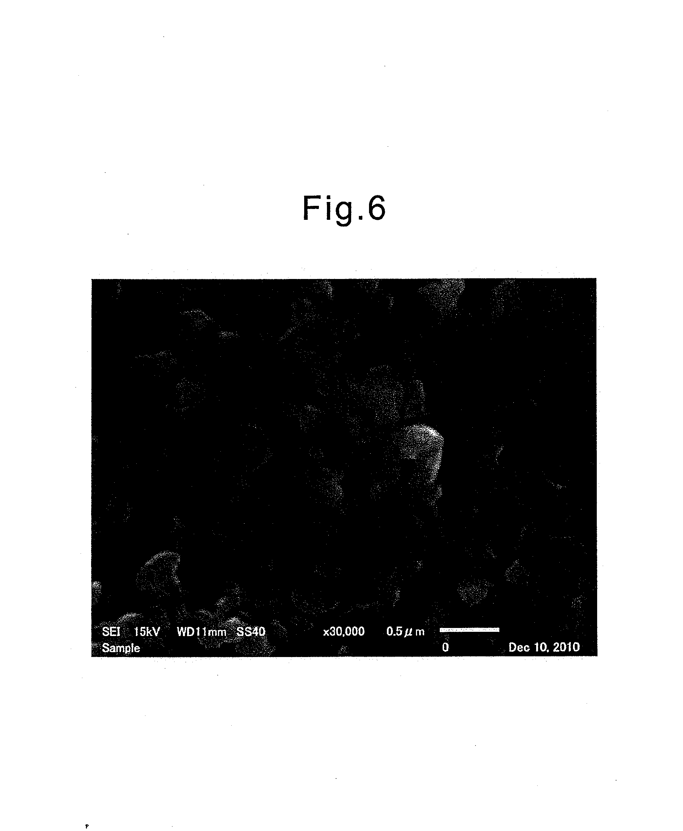

Regarding the powder obtained in Example 1, additional observation was performed using a scanning electron microscope (SEM: JSM-6010LA, manufactured by JOEL Co., Ltd., element analysis, acceleration voltage: 15 kW, magnification: x30000). FIG. 6 depicts an obtained SEM image. This indicated that particles with a size of 500 nm or less were produced.

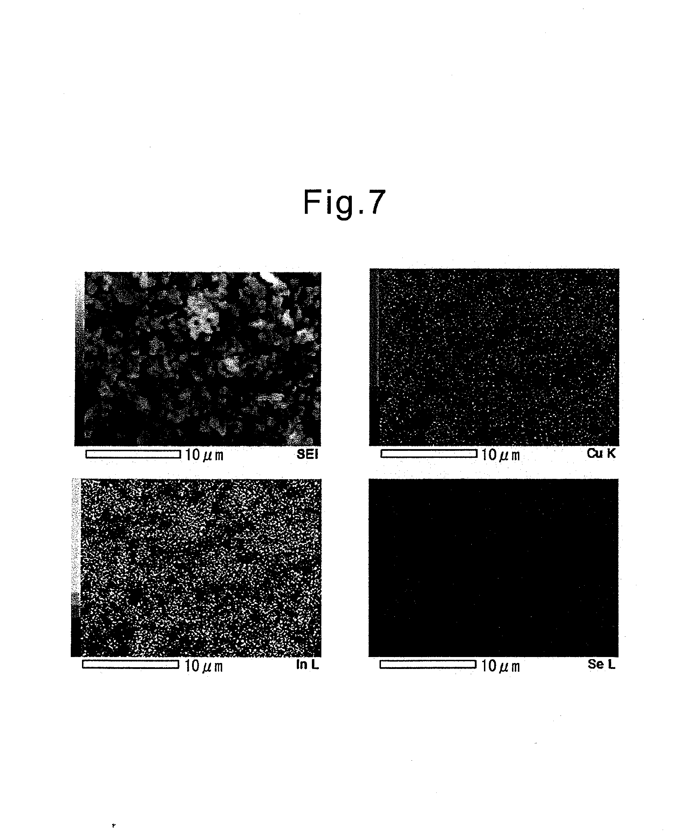

Regarding the powder obtained in Example 1, additional analysis was performed using Energy Dispersive X-ray Spectroscopy (EDS: JSM-6010LA, manufactured by JOEL Co., Ltd., acceleration voltage: 20 kW, magnification: ×5000). FIGs. 7 depict obtained EDS images. The image on the upper left is a secondary electron image (SEI) in which particles are found to be uniformly present in the entire picture. The upper right one is a Cu mapping image; the lower left one is an In mapping image; and the lower right one is an Se mapping image. All the mappings indicate uniform presences of the respective elements in the respective entire pictures. From these images, the powder obtained in Example 1 seems to uniformly contain Cu, In, and Se. This verifies the production of CuIn_{0.5}GaO_{0.5}Se₂ confirmed by the above XRD result (FIG. 2). Although not depicted in FIG. 7, the uniform presence of Ga was similarly confirmed.

## Claims

1. A method for producing a compound having a chalcopyrite structure represented by a compositional formula: ABC₂, the method comprising:
a step of dissolving a Group 11 element A, a Group 13 element B, and a Group 16 element C of the periodic table in a solvent to prepare a solution; and
a step of contacting the solution with a reducing agent.

2. The method according to claim 1, wherein the compound having a chalcopyrite structure is present in a dispersed state in the solution.

3. The method according to claim 1 or 2, wherein the compound having a chalcopyrite structure includes particles in size from nanometer to submicron order.

4. The method according to any one of claims 1 to 3, wherein the Group 11 element A, the Group 13 element B, and the Group 16 element C are prepared in a form of a compound or a single substance having solubility in the solvent at 20±15°C.

5. The method according to claim 4, wherein in the compound of the Group 16 element C, the valence of the Group 16 element C is not -II.

6. The method according to any one of claims 1 to 5, wherein the solvent comprises at least one of a polar solvent and a nonpolar solvent.

7. The method according to any one of claims 1 to 6, wherein the polar solvent and the nonpolar solvent are used in combination as the solvent and these solvents are contacted with a phase-transfer catalyst.

8. The method according to any one of claims 1 to 7, wherein the reducing agent is at least one selected from the group consisting of a hydride reducing agent, hydrazine, oxalic acid, ascorbic acid, formaldehyde, acetaldehyde, and sodium sulfite, or a combination of any thereof.

9. A method for producing a coating type material or a physical vapor deposition (PVD) material using a compound having a chalcopyrite structure produced by the method according to any one of claims 1 to 8.

10. A method for producing an optoelectronic device using a compound having a chalcopyrite structure produced by the method according to any one of claims 1 to 8.

11. The method according to claim 10, wherein the optoelectronic device is a solar cell or a photodiode.
